(19)

Europäisches Patentamt
European Patent Office
Office européen des brevets

(11)  **EP 4 149 007 A1**

(12)  **EUROPEAN PATENT APPLICATION**

(43) Date of publication:
**15.03.2023 Bulletin 2023/11**

(21) Application number: **22179044.7**

(22) Date of filing: **14.06.2022**

(51) International Patent Classification (IPC):
***H03M 7/30*** (2006.01)          ***G06N 3/08*** (2006.01)
***G06F 17/17*** (2006.01)

(52) Cooperative Patent Classification (CPC):
**H03M 7/3082; G06F 17/175; G06N 3/082;**
**H03M 7/3059; H03M 7/70**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **09.09.2021   JP 2021146728**

(71) Applicant: **FUJITSU LIMITED**
**Kawasaki-shi, Kanagawa 211-8588 (JP)**

(72) Inventor: **TAMIYA, Yutaka**
**Kawasaki-shi, 211-8588 (JP)**

(74) Representative: **Haseltine Lake Kempner LLP**
**Cheapside House**
**138 Cheapside**
**London EC2V 6BJ (GB)**

(54)  **ARITHMETIC PROGRAM, ARITHMETIC METHOD, AND ARITHMETIC DEVICE**

(57)    A computer-implemented method of an arithmetic processing, the method including: identifying maximum absolute values of individual dimensions by projecting a maximum absolute value in a direction of each of the individual dimensions of a tensor represented by a multidimensional array, the tensor in which a value is set for each of elements of the array; identifying a minimum value that indicates a minimum maximum absolute value among the maximum absolute values of the individual dimensions; and setting a quantization range for the tensor on a basis of the minimum value.

# FIG. 1

**Description**

FIELD

The embodiments discussed herein are related to an arithmetic program and the like.

BACKGROUND

In deep learning, there is a method of quantizing data values to speed up a process of machine learning for a learning model. Here, an existing technique of quantizing a tensor used for the machine learning will be described.

A value of the tensor is expressed by the formula (1). Element data of the tensor is represented by an FP format (s-ebit-mbit) and an exponent part bias b. For example, in the example indicated by the formula (1), s represents a 1-bit fixed sign bit. The number of bits in the exponent part e is represented by ebit. The number of bits in the mantissa m is represented by mbit. A bias value of the exponent part is represented by b. All elements in the tensor use the same ebit, mbit, and b.

[Formula 1]

$$\text{value} = (-1)^s \left( 1 + \sum_{i=1}^{mbit} m_i 2^{-i} \right) \times 2^{e - (2^{ebit-1} - 1) + b} \qquad \cdots (1)$$

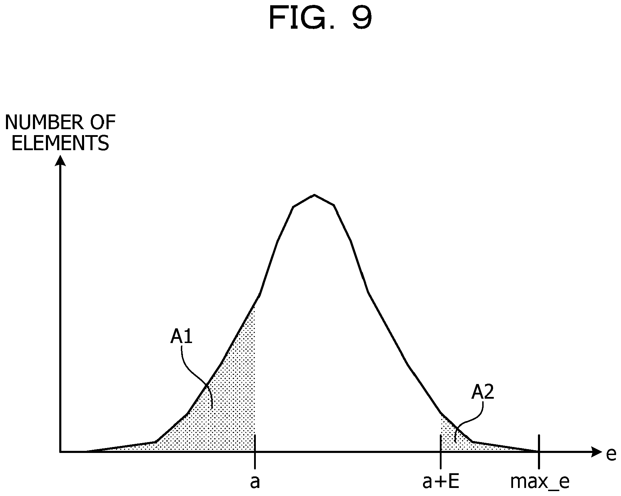

In the existing technique, there is a rounding range due to the upper and lower quantization. FIG. 9 is a diagram for explaining the existing technique. The horizontal axis of the histogram in FIG. 9 corresponds to the value of the exponent part e, and the vertical axis represents the number of elements. According to the existing technique, in a case where a quantization target range is set to [a, a + E], elements in a lower range A1 in which the exponent part e is less than a are rounded to 0. Furthermore, elements in an upper range A2 in which the exponent part e is equal to or greater than a + E are rounded to $2^{(a+E)}$. A quantization exponent width is represented by E, which is, for example, $E = 2^{ebit}$.

According to the existing technique, the quantization target range is calculated on the basis of the maximum absolute value (max_e) of an element of a quantization target tensor T. The maximum absolute value is calculated on the basis of the formula (2).

[Formula 2]

$$\text{max\_e} = \max_{x \in T} [\log_2 \text{abs}(x)] - E \qquad \cdots (2)$$

International Publication Pamphlet No. WO 2020/065874, International Publication Pamphlet No. WO 2019/146189, and U.S. Patent Application Publication No. 2019/0340492 are disclosed as related art.

SUMMARY

TECHNICAL PROBLEM

However, the existing technique described above has a problem that a mathematical property of the tensor changes at a time of quantizing the tensor.

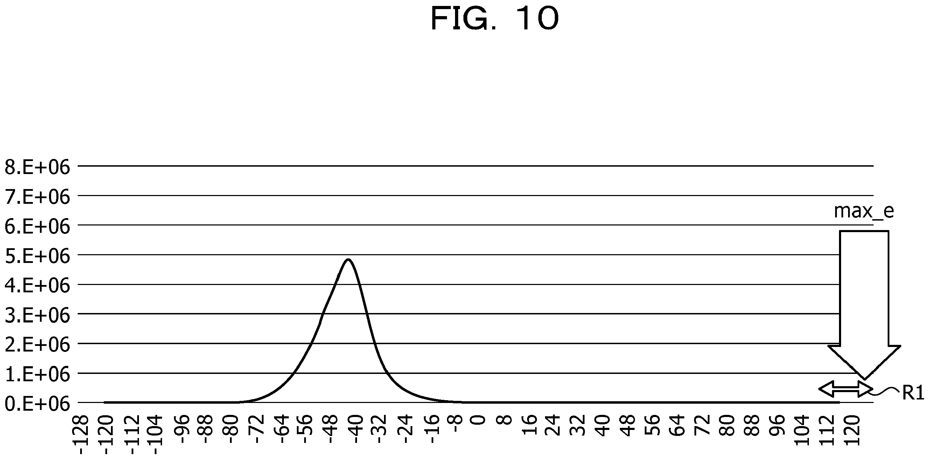

FIG. 10 is a diagram for explaining the problem of the existing technique. The horizontal axis of the histogram in FIG. 10 corresponds to the value of the exponent part e, and the vertical axis represents the number of elements. In a case where a part of the elements of the exponent part e has a large value, a quantization target range R1 is biased upward, and a large majority of the other elements are rounded to 0. In the example illustrated in FIG. 10, equal to or more than 99.9% of the non-zero elements in the tensor are rounded to 0. When rounded in this manner, characteristics such as the number of ranks of the tensor are not saved, and the mathematical property changes.

It is desirable to provide an arithmetic program, an arithmetic method, and an arithmetic device capable of quantizing a tensor without changing a mathematical property of the tensor.

SOLUTION TO PROBLEM

According to an embodiment of one aspect of the invention, there is provided a computer-implemented method of an arithmetic processing. In an example, the method includes: identifying maximum absolute values of individual dimensions by projecting a maximum absolute value in a direction of each of the individual dimensions of a tensor represented by a multidimensional array, the tensor in which a value is set for each of elements of the array; identifying a minimum value that indicates a minimum maximum absolute value among the maximum absolute values of the individual dimensions; and setting a quantization range for the tensor on a basis of the minimum value.

ADVANTAGEOUS EFFECTS OF INVENTION

It becomes possible to quantize a tensor without changing a mathematical property of the tensor.

BRIEF DESCRIPTION OF DRAWINGS

The invention is described, by way of example only, with reference to the following drawings, in which:

FIG. 1 is a diagram for explaining processing of an arithmetic device according to a first embodiment;
FIG. 2 is a diagram illustrating a result of comparison between quantization of the arithmetic device according to the first embodiment and quantization of an existing technique;
FIG. 3 is a functional block diagram illustrating a configuration of the arithmetic device according to the first embodiment;
FIG. 4 is a flowchart illustrating a processing procedure of the arithmetic device according to the first embodiment;
FIG. 5 is a diagram for explaining processing of an arithmetic device according to a second embodiment;
FIG. 6 is a functional block diagram illustrating a configuration of the arithmetic device according to the second embodiment;
FIG. 7 is a flowchart illustrating a processing procedure of the arithmetic device according to the second embodiment;
FIG. 8 is a diagram illustrating an exemplary hardware configuration of a computer that implements functions similar to those of the arithmetic device according to the embodiments;
FIG. 9 is a diagram for explaining an existing technique; and
FIG. 10 is a diagram for explaining a problem of the existing technique.

DESCRIPTION OF EMBODIMENTS

Hereinafter, embodiments of an arithmetic program, an arithmetic method, and an arithmetic device disclosed in the present application will be described in detail with reference to the drawings. Note that the embodiments do not limit the present disclosure.

[First Embodiment]

An arithmetic device according to a first embodiment executes the following processing to set a range of quantization in order to quantize a tensor without changing a mathematical property of the tensor.

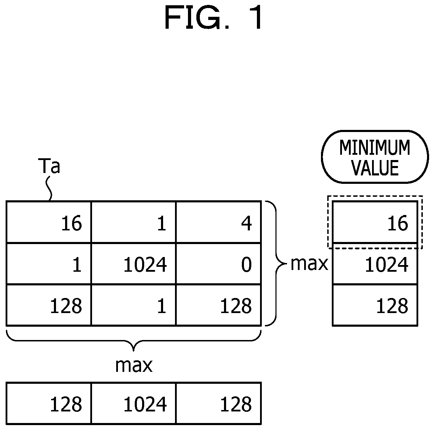

FIG. 1 is a diagram for explaining processing of the arithmetic device according to the first embodiment. FIG. 1 gives explanation using a two-dimensional tensor Ta. A value of an exponent part e is set for each element of the tensor Ta. For example, "16", "1", and "4" are set for elements (0, 0), (0, 1), and (0, 2) of the tensor Ta, respectively. Values "1", "1,024", and "0" are set for elements (1, 0), (1, 1), and (1, 2) of the tensor Ta, respectively. Values "128", "1", and "128" are set for elements (2, 0), (2, 1), and (2, 2) of the tensor Ta, respectively.

The arithmetic device projects the maximum absolute value in the direction of each of dimensions, thereby identifying the individual maximum absolute values of the dimensions. For example, the arithmetic device projects the maximum absolute value in the row direction of the elements (0, 0), (0, 1), and (0, 2), thereby identifying "16". The arithmetic device projects the maximum absolute value in the row direction of the elements (1, 0), (1, 1), and (1, 2), thereby identifying "1,024". The arithmetic device projects the maximum absolute value in the row direction of the elements (2, 0), (2, 1), and (2, 2), thereby identifying "128".

The arithmetic device projects the maximum absolute value in the column direction of the elements (0, 0), (1, 0), and (2, 0), thereby identifying "128". The arithmetic device projects the maximum absolute value in the column direction of the elements (0, 1), (1, 1), and (2, 1), thereby identifying "1,024". The arithmetic device projects the maximum absolute value in the column direction of the elements (0, 2), (1, 2), and (2, 2), thereby identifying "128".

The arithmetic device identifies the minimum maximum absolute value among the maximum absolute values of the individual dimensions identified by the processing described above. In the following descriptions, the minimum maximum absolute value will be referred to as a "minimum value a". In the example illustrated in FIG. 1, the arithmetic device identifies the minimum value a "16" from the maximum absolute values 16, 1,024, 128, 128, 1,024, and 128.

The arithmetic device specifies "rank_e" on the basis of the minimum value a. On the basis of the formula (3), rank_e is specified. When the minimum value a = 16, rank_e = 4.

$$\text{rank\_e} = [\log_2 a] \quad ...(3)$$

The arithmetic device sets a quantization range on the basis of rank_e. For example, it is assumed that the quantization range is [rank_e, rank_e + E]. Here, E represents a quantization exponent width, and is specified in advance. In a case where rank_e = 4 and E = 2, the quantization range is [4, 5].

Meanwhile, according to the existing technique, the quantization range is determined on the basis of max_e. There is a relation of $\text{max\_e} = \log_2(a' + E)$, and a' represents the maximum absolute value of each element of the tensor Ta. The quantization range based on max_e is $[\log_2 a', \log_2(a' + E)]$. For example, the maximum absolute value a' of the tensor Ta illustrated in FIG. 1 is "1,024", and the quantization range based on max_e is [9, 10].

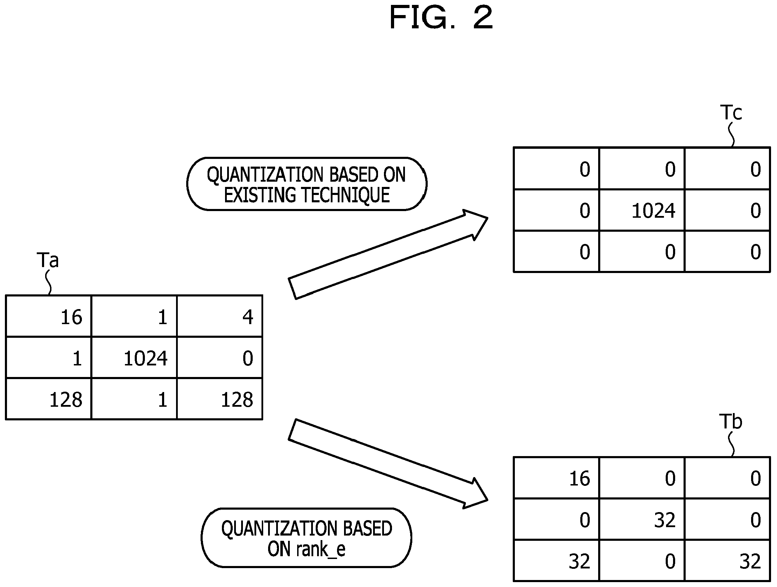

FIG. 2 is a diagram illustrating a result of comparison between the quantization of the arithmetic device according to the first embodiment and the quantization of the existing technique. As illustrated in FIG. 2, when the quantization is carried out with rank_e, the quantization range is [4, 5], and thus the tensor Ta is quantized into a tensor Tb. According to such quantization, an element with an absolute value larger than 16 (= $2^4$) remains as non-zero, whereby a decrease in rank is suppressed and it becomes possible to quantize the tensor without changing the mathematical property of the tensor.

Meanwhile, when the quantization is carried out with max_e as in the existing technique, the quantization range is "9, 10", and the tensor Ta is quantized into a tensor Tc. According to such quantization, only the maximum value 1,024 (=$2^{10}$) becomes a non-zero element, and the rank is also lowered to 1, whereby the mathematical property of the tensor is greatly impaired.

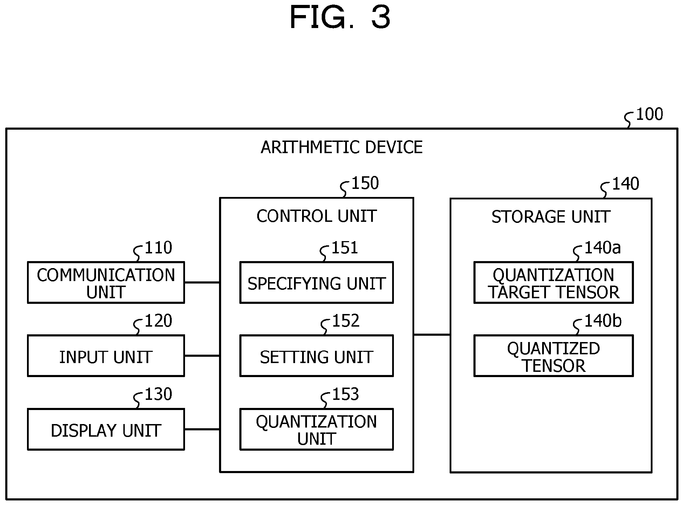

Next, an exemplary configuration of the arithmetic device according to the first embodiment will be described. FIG. 3 is a functional block diagram illustrating a configuration of the arithmetic device according to the first embodiment. As illustrated in FIG. 3, this arithmetic device 100 includes a communication unit 110, an input unit 120, a display unit 130, a storage unit 140, and a control unit 150.

The communication unit 110 is connected to an external device or the like by wire or wirelessly, and exchanges information with the external device or the like. For example, the communication unit 110 is implemented by a network interface card (NIC) or the like. The communication unit 110 may be connected to a network (not illustrated). The communication unit 110 may receive a quantization target tensor 140a from an external device via the network.

The input unit 120 is an input device that inputs various types of information to the arithmetic device 100. The input unit 120 corresponds to a keyboard, a mouse, a touch panel, or the like.

The display unit 130 is a display device that displays information output from the control unit 150. The display unit 130 corresponds to a liquid crystal display, an organic electro luminescence (EL) display, a touch panel, or the like.

The storage unit 140 includes the quantization target tensor 140a and a quantized tensor 140b. The storage unit 140 is implemented by, for example, a semiconductor memory element such as a random access memory (RAM), a flash memory, or the like, or a storage device such as a hard disk, an optical disk, or the like.

The quantization target tensor 140a indicates a tensor to be quantized. In the first embodiment, the quantization target tensor 140a is to be the two-dimensional tensor Ta described with reference to FIG. 1.

The quantized tensor 140b is a tensor obtained as a result of quantizing the quantization target tensor 140a. For example, the quantized tensor 140b corresponds to the tensor Tb described with reference to FIG. 2.

The control unit 150 includes a specifying unit 151, a setting unit 152, and a quantization unit 153. The control unit 150 is implemented by, for example, a central processing unit (CPU) or a micro processing unit (MPU). Furthermore, the control unit 150 may be implemented by, for example, an integrated circuit such as an application specific integrated circuit (ASIC), a field programmable gate array (FPGA), or the like.

The specifying unit 151 projects the maximum absolute value in the direction of each dimension of the quantization target tensor 140a, thereby identifying the maximum absolute value of each dimension. The specifying unit 151 identifies the minimum value a indicating the minimum maximum absolute value among the maximum absolute values of the individual dimensions. The specifying unit 151 outputs information regarding the minimum value a to the setting unit 152.

Processing of the specifying unit 151 will be described with reference to FIG. 1. The specifying unit 151 projects the maximum absolute value in the row direction of the elements (0, 0), (0, 1), and (0, 2) of the tensor Ta (quantization target tensor 140a), thereby identifying "16". The specifying unit 151 projects the maximum absolute value in the row direction of the elements (1, 0), (1, 1), and (1, 2), thereby identifying "1,024". The specifying unit 151 projects the maximum absolute value in the row direction of the elements (2, 0), (2, 1), and (2, 2), thereby identifying "128".

The specifying unit 151 projects the maximum absolute value in the column direction of the elements (0, 0), (1, 0), and (2, 0), thereby identifying "128". The specifying unit 151 projects the maximum absolute value in the column direction of the elements (0, 1), (1, 1), and (2, 1), thereby identifying "1,024". The specifying unit 151 projects the maximum absolute value in the column direction of the elements (0, 2), (1, 2), and (2, 2), thereby identifying "128".

The specifying unit 151 identifies the minimum value a from the maximum absolute values of the individual dimensions identified by the process described above. In the example illustrated in FIG. 1, the specifying unit 151 identifies the minimum value a "16" from the maximum absolute values 16, 1,024, 128, 128, 1,024, and 128.

The setting unit 152 sets a quantization range for the quantization target tensor 140a on the basis of the minimum value a. The setting unit 152 outputs information regarding the quantization range to the quantization unit 153.

The setting unit 152 specifies rank_e on the basis of the minimum value a and the formula (3). The setting unit 152 sets the quantization range [rank_e, rank_e + E] on the basis of rank_e. For example, in a case where the minimum value a = 16, rank_e = 4 and the quantization range is [4, 5].

The quantization unit 153 quantizes the quantization target tensor 140a within the quantization range received from the setting unit 152, thereby generating a quantized tensor 140b.

Processing of the quantization unit 153 will be described with reference to FIG. 2. Here, the quantization target tensor 140a is to be the tensor Ta, and the quantization range is to be [4, 5]. According to such quantization, an element with an absolute value larger than 16 (= $2^4$) remains as non-zero, and for example, a quantization result of the tensor Ta is tensor Tb (quantized tensor 140b).

The quantization unit 153 may transmit the quantized tensor 140b to an external device serving as a transmission source of the quantization target tensor 140a. For example, such an external device executes machine learning of a learning model using the quantized tensor 140b. Note that, although illustration is omitted, the arithmetic device 100 may execute the machine learning of the learning model using the quantized tensor 140b.

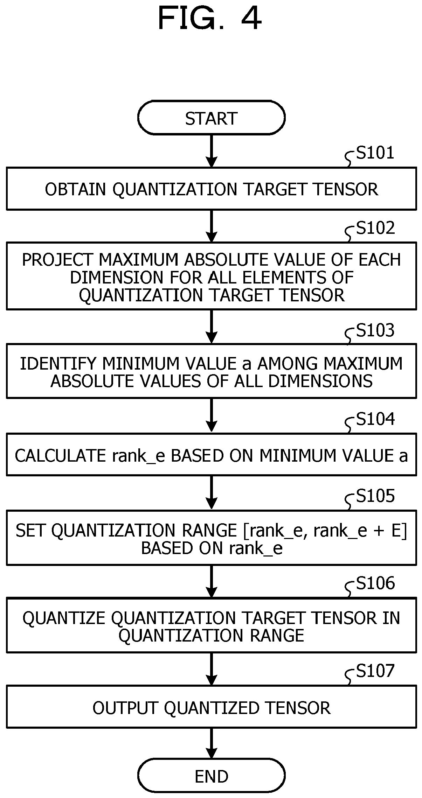

Next, an exemplary processing procedure of the arithmetic device 100 according to the first embodiment will be described. FIG. 4 is a flowchart illustrating a processing procedure of the arithmetic device according to the first embodiment. As illustrated in FIG. 4, the specifying unit 151 of the arithmetic device 100 obtains the quantization target tensor 140a (step S101).

The specifying unit 151 projects the maximum absolute value of each dimension for all the elements of the quantization target tensor 140a (step S102). The specifying unit 151 identifies the minimum value a among the maximum absolute values of all dimensions (step S103).

The setting unit 152 of the arithmetic device 100 calculates rank_e on the basis of the minimum value a (step S104). The setting unit 152 sets the quantization range [rank_e, rank_e + E] on the basis of rank_e (step S105).

The quantization unit 153 of the arithmetic device 100 quantizes the quantization target tensor 140a in the quantization range (step S106). The quantization unit 153 outputs the quantized tensor 140b (step S107).

Next, effects of the arithmetic device 100 according to the first embodiment will be described. The arithmetic device 100 projects the maximum absolute value in the direction of each of dimensions of the quantization target tensor 140a to identify the maximum absolute value of each of the dimensions, and identifies the minimum value a from the maximum absolute values of the individual dimensions. The arithmetic device 100 sets the quantization range on the basis of the minimum value a to carry out quantization. This makes it possible to quantize the tensor without changing the mathematical property of the tensor.

For example, as described with reference to FIG. 2, since the quantization range is [4, 5] according to the arithmetic device 100, the tensor Ta is quantized into the tensor Tb. According to such quantization, an element with an absolute value larger than 16 (= $2^4$) remains as non-zero, whereby a decrease in rank is suppressed and the mathematical property of the tensor is saved.

Meanwhile, when the quantization is carried out with max_e as in the existing technique, the quantization range is "9, 10", and the tensor Ta is quantized into a tensor Tc. According to such quantization, only the maximum value 1,024 (= $2^{10}$) becomes a non-zero element, and the rank is also lowered to 1, whereby the mathematical property of the tensor is greatly impaired.

[Second Embodiment]

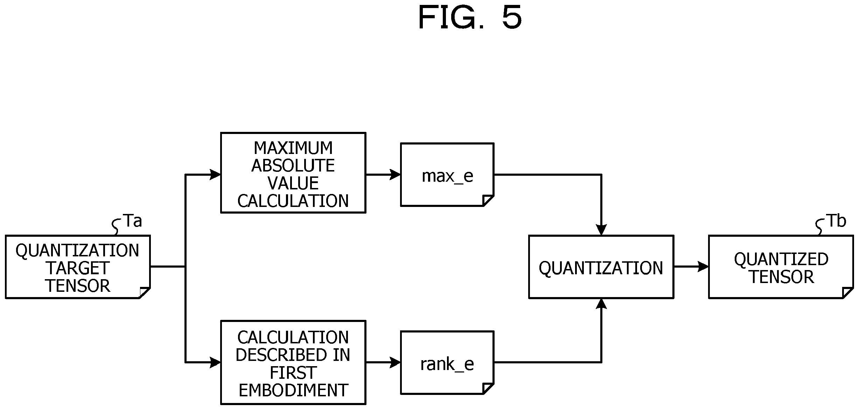

FIG. 5 is a diagram for explaining processing of an arithmetic device according to a second embodiment. As illustrated in FIG. 5, in a similar manner to the existing technique, the arithmetic device according to the second embodiment calculates a maximum absolute value from a quantization target tensor Ta, thereby obtaining max_e. The arithmetic device performs calculation similar to that in the first embodiment, and calculates rank_e from the quantization target tensor Ta. The arithmetic device identifies a smaller minimum value e0 of rank_e and max_e. The minimum value e0 is identified on the basis of the formula (4). The arithmetic device sets a quantization range [e0, e0 + E] using the minimum value e0, and quantize the quantization target tensor Ta, thereby obtaining a quantized tensor Tb.

$$e0 = \min(rank\_e, max\_e) \ ...(4)$$

The arithmetic device according to the second embodiment identifies the smaller minimum value e0 of rank_e and max_e, and sets the quantization range [e0, e0 + E] using the minimum value e0, whereby it is enabled to quantize the tensor more appropriately, and to enhance learning accuracy at the time of executing machine learning.

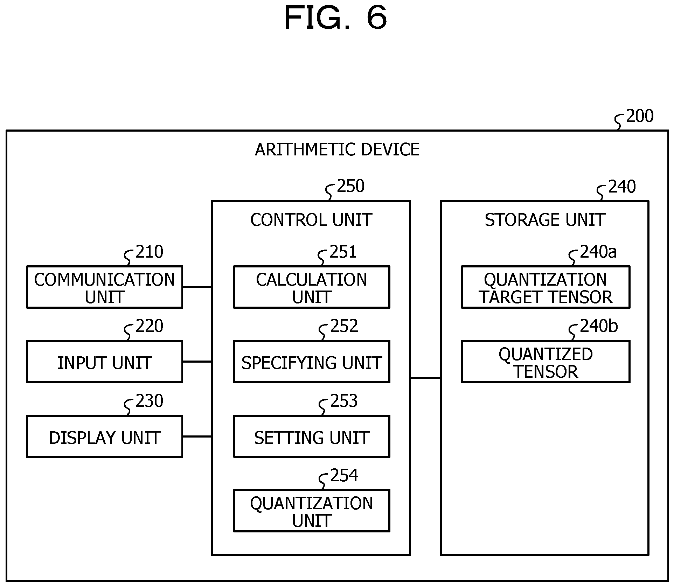

FIG. 6 is a functional block diagram illustrating a configuration of the arithmetic device according to the second embodiment. As illustrated in FIG. 6, this arithmetic device 200 includes a communication unit 210, an input unit 220, a display unit 230, a storage unit 240, and a control unit 250.

Descriptions regarding the communication unit 210, the input unit 220, and the display unit 230 are similar to the descriptions regarding the communication unit 110, the input unit 120, and the display unit 130 described with reference to FIG. 3.

The storage unit 240 includes a quantization target tensor 240a and a quantized tensor 240b. The storage unit 240 is implemented by, for example, a semiconductor memory element such as a RAM, a flash memory, or the like, or a storage device such as a hard disk, an optical disk, or the like.

Description regarding the quantization target tensor 240a is similar to the description regarding the quantization target tensor 140a. Description regarding the quantized tensor 240b is similar to the description regarding the quantized tensor 140b.

The control unit 250 includes a calculation unit 251, a specifying unit 252, a setting unit 253, and a quantization unit 254. The control unit 250 is implemented by, for example, a CPU or an MPU. Furthermore, the control unit 250 may be implemented by, for example, an integrated circuit such as an ASIC, an FPGA, or the like.

The calculation unit 251 calculates max_e, which is the maximum absolute value, among all the elements of the quantization target tensor 240a. For example, the calculation unit 251 calculates max_e using the formula (2) mentioned above. The calculation unit 251 outputs information regarding max_e to the setting unit 253.

The specifying unit 252 identifies the minimum value a on the basis of the quantization target tensor 240a. A process in which the specifying unit 252 identifies the minimum value a is similar to the process in which the specifying unit 151 identifies the minimum value a described in the first embodiment. The specifying unit 252 outputs information regarding the minimum value a to the setting unit 253.

The setting unit 253 specifies rank_e on the basis of the minimum value a and the formula (3). The setting unit 253 identifies the minimum value e0 on the basis of the formula (4), rank_e, and max_e. The setting unit 253 sets the quantization range [e0, e0 + E] using the minimum value e0. The setting unit 253 outputs information regarding the quantization range to the quantization unit 254.

The quantization unit 254 quantizes the quantization target tensor 240a within the quantization range received from the setting unit 253, thereby generating a quantized tensor 240b. Processing of the quantization unit 254 is similar to the processing of the quantization unit 153 described in the first embodiment.

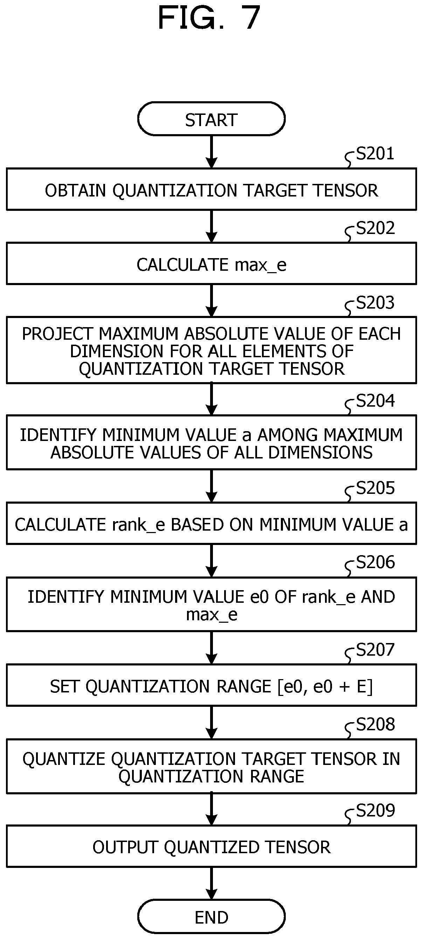

Next, an exemplary processing procedure of the arithmetic device 200 according to the second embodiment will be described. FIG. 7 is a flowchart illustrating a processing procedure of the arithmetic device according to the second embodiment. The calculation unit 251 of the arithmetic device 200 obtains the quantization target tensor 240a (step S201).

The calculation unit 251 calculates max_e on the basis of the quantization target tensor 240a (step S202). The specifying unit 252 of the arithmetic device 200 projects the maximum absolute value of each dimension for all the elements of the quantization target tensor 240a (step S203). The specifying unit 252 identifies the minimum value a among the maximum absolute values of all dimensions (step S204).

The setting unit 253 of the arithmetic device 200 calculates rank_e on the basis of the minimum value a (step S205). The setting unit 253 identifies the minimum value e0 of rank_e and max_e (step S206). The setting unit 253 sets the quantization range [e0, e0 + E] on the basis of the minimum value e0 (step S207).

The quantization unit 254 of the arithmetic device 200 quantizes the quantization target tensor 240a in the quantization range (step S208). The quantization unit 254 outputs the quantized tensor 240b (step S209).

Next, effects of the arithmetic device 200 according to the second embodiment will be described. The arithmetic device 200 identifies the minimum value e0 from max_e and rank_e obtained from the quantization target tensor 240a, and sets the quantization range on the basis of the minimum value e0 to carry out quantization. As a result, it becomes possible to quantize the tensor more appropriately, and to enhance the learning accuracy at the time of executing the machine learning.

Meanwhile, while the setting unit 253 sets the smaller one of rank_e and max_e as the minimum value e0 to set the quantization range in the second embodiment described above, it is not limited to this. The setting unit 253 may calculate a weighted sum ew of rank_e and max_e to set the quantization range on the basis of the weighted sum ew.

For example, the setting unit 253 calculates the weighted sum ew on the basis of the formula (5). In the formula (5), c represents a constant, which is set in a range of $0 \leq c \leq 1$. The setting unit 253 sets the quantization range as [ew, ew + E].

$$ew = c*rank\_e + (1 - c)*max\_e \; ...(5)$$

Here, the inventor measured learning accuracy for a learning model for a tensor (first tensor) quantized by the existing technique, a tensor (second tensor) quantized by the method of the first embodiment, and a tensor (third tensor) quantized by the method (weighted sum) of the second embodiment. As a result, the learning accuracy of the first tensor was "79.30%", the learning accuracy of the second tensor was "79.89%", and the learning accuracy of the third tensor was "80.27%". For example, according to the quantization methods of the first and second embodiments, it is possible to enhance the learning accuracy at the time of executing the machine learning as compared with the existing technique.

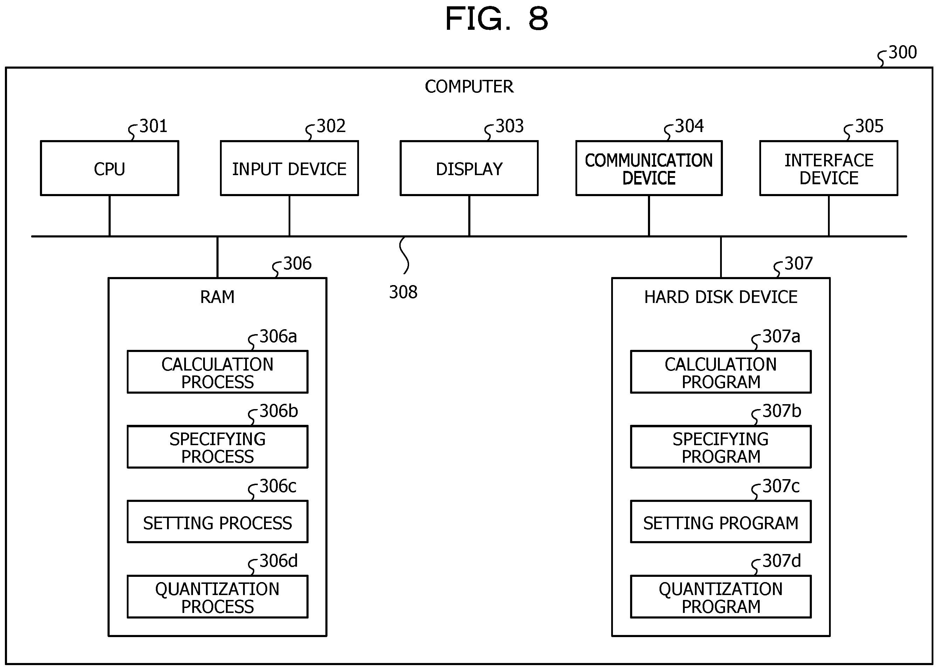

Next, an exemplary hardware configuration of a computer that implements functions similar to those of the arithmetic device 200 (100) indicated in the embodiments described above will be described. FIG. 8 is a diagram illustrating an exemplary hardware configuration of a computer that implements functions similar to those of the arithmetic device according to the embodiments.

As illustrated in FIG. 8, a computer 300 includes a CPU 301 that executes various types of arithmetic processing, an input device 302 that receives data input from a user, and a display 303. Furthermore, the computer 300 includes a communication device 304 that exchanges data with an external device or the like via a wired or wireless network, and an interface device 305. Furthermore, the computer 300 includes a RAM 306 that temporarily stores various types of information, and a hard disk device 307. Additionally, each of the devices 301 to 307 is connected to a bus 308.

The hard disk device 307 includes a calculation program 307a, a specifying program 307b, a setting program 307c, and a quantization program 307d. Furthermore, the CPU 301 reads each of the programs 307a to 307d, and loads it in the RAM 306.

The calculation program 307a functions as a calculation process 306a. The specifying program 307b functions as a specifying process 306b. The setting program 307c functions as a setting process 306c. The quantization program 307d functions as a quantization process 306d.

Processing of the calculation process 306a corresponds to the processing of the calculation unit 251. Processing of the specifying process 306b corresponds to the processing of the specifying units 151 and 252. Processing of the setting process 306c corresponds to the processing of the setting units 152 and 253. Processing of the quantization process 306d corresponds to the processing of the quantization units 153 and 254.

Note that each of the programs 307a to 307d may not necessarily be stored in the hard disk device 307 beforehand. For example, each of the programs is stored in a "portable physical medium" to be inserted in the computer 300, such as a flexible disk (FD), a compact disc read only memory (CD-ROM), a digital versatile disc (DVD), a magneto-optical disk, an IC card, or the like. Then, the computer 300 may read and execute each of the programs 307a to 307d.

In any of the above aspects, the various features may be implemented in hardware, or as software modules running on one or more processors/computers.

The invention also provides a computer program or a computer program product comprising instructions which, when executed by a computer, cause the computer to carry out any of the methods/method steps described herein, and a non-transitory computer-readable medium comprising instructions which, when executed by a computer, cause the computer to carry out any of the methods/method steps described herein. A computer program embodying the invention may be stored on a non-transitory computer-readable medium, or it could, for example, be in the form of a signal such as a downloadable data signal provided from an Internet website, or it could be in any other form.

## Claims

1. An arithmetic program comprising instructions which, when executed by a computer, cause the computer to execute processing comprising:

   identifying maximum absolute values of individual dimensions by projecting a maximum absolute value in a direction of each of the individual dimensions of a tensor represented by a multidimensional array, the tensor in which a value is set for each of elements of the array;
   identifying a minimum value that indicates a minimum maximum absolute value among the maximum absolute values of the individual dimensions; and

setting a quantization range for the tensor on a basis of the minimum value.

2. The arithmetic program according to claim 1, wherein the setting the quantization range sets the quantization range on a basis of a smaller value of the minimum value and a value obtained by subtracting a value that corresponds to the quantization range from the maximum absolute value of all the elements included in the tensor.

3. The arithmetic program according to claim 1 or 2, wherein the setting the quantization range sets the quantization range on a basis of a weighted sum of the minimum value and a value obtained by subtracting a value that corresponds to the quantization range from the maximum absolute value of all the elements included in the tensor.

4. The arithmetic program according to any preceding claim, the processing further comprising: quantizing the tensor on a basis of the quantization range set for the tensor.

5. A computer-implemented method of an arithmetic processing, the method comprising:

identifying maximum absolute values of individual dimensions by projecting a maximum absolute value in a direction of each of the individual dimensions of a tensor represented by a multidimensional array, the tensor in which a value is set for each of elements of the array;
identifying a minimum value that indicates a minimum maximum absolute value among the maximum absolute values of the individual dimensions; and
setting a quantization range for the tensor on a basis of the minimum value.

6. An arithmetic apparatus comprising:

a memory; and
a processor coupled to the memory, the processor being configured to perform processing including:

identifying maximum absolute values of individual dimensions by projecting a maximum absolute value in a direction of each of the individual dimensions of a tensor represented by a multidimensional array, the tensor in which a value is set for each of elements of the array;
identifying a minimum value that indicates a minimum maximum absolute value among the maximum absolute values of the individual dimensions; and
setting a quantization range for the tensor on a basis of the minimum value.

# FIG. 1

Ta

| 16 | 1 | 4 |
|---|---|---|
| 1 | 1024 | 0 |
| 128 | 1 | 128 |

} max

max

| 128 | 1024 | 128 |
|---|---|---|

MINIMUM VALUE

| 16 |
|---|
| 1024 |
| 128 |

# FIG. 2

# FIG. 3

ARITHMETIC DEVICE ς100

CONTROL UNIT ς150

STORAGE UNIT ς140

COMMUNICATION UNIT ς110

INPUT UNIT ς120

DISPLAY UNIT ς130

SPECIFYING UNIT ς151

SETTING UNIT ς152

QUANTIZATION UNIT ς153

QUANTIZATION TARGET TENSOR ς140a

QUANTIZED TENSOR ς140b

# FIG. 4

```
        ┌─────────────┐
        │    START    │
        └─────────────┘
               │
               ▼               ╭S101
┌──────────────────────────────────────┐
│   OBTAIN QUANTIZATION TARGET TENSOR    │
└──────────────────────────────────────┘
               │
               ▼               ╭S102
┌──────────────────────────────────────┐
│  PROJECT MAXIMUM ABSOLUTE VALUE OF EACH │
│     DIMENSION FOR ALL ELEMENTS OF       │
│     QUANTIZATION TARGET TENSOR          │
└──────────────────────────────────────┘
               │
               ▼               ╭S103
┌──────────────────────────────────────┐
│  IDENTIFY MINIMUM VALUE a AMONG MAXIMUM │
│   ABSOLUTE VALUES OF ALL DIMENSIONS     │
└──────────────────────────────────────┘
               │
               ▼               ╭S104
┌──────────────────────────────────────┐
│  CALCULATE rank_e BASED ON MINIMUM VALUE a │
└──────────────────────────────────────┘
               │
               ▼               ╭S105
┌──────────────────────────────────────┐
│  SET QUANTIZATION RANGE [rank_e, rank_e + E] │
│         BASED ON rank_e                  │
└──────────────────────────────────────┘
               │
               ▼               ╭S106
┌──────────────────────────────────────┐
│  QUANTIZE QUANTIZATION TARGET TENSOR IN │
│         QUANTIZATION RANGE              │
└──────────────────────────────────────┘
               │
               ▼               ╭S107
┌──────────────────────────────────────┐
│       OUTPUT QUANTIZED TENSOR          │
└──────────────────────────────────────┘
               │
               ▼
        ┌─────────────┐
        │     END     │
        └─────────────┘
```

EP 4 149 007 A1

# FIG. 5

# FIG. 6

# FIG. 7

START

S201

OBTAIN QUANTIZATION TARGET TENSOR

S202

CALCULATE max_e

S203

PROJECT MAXIMUM ABSOLUTE VALUE OF EACH
DIMENSION FOR ALL ELEMENTS OF
QUANTIZATION TARGET TENSOR

S204

IDENTIFY MINIMUM VALUE a AMONG MAXIMUM
ABSOLUTE VALUES OF ALL DIMENSIONS

S205

CALCULATE rank_e BASED ON MINIMUM VALUE a

S206

IDENTIFY MINIMUM VALUE e0 OF rank_e AND
max_e

S207

SET QUANTIZATION RANGE [e0, e0 + E]

S208

QUANTIZE QUANTIZATION TARGET TENSOR IN
QUANTIZATION RANGE

S209

OUTPUT QUANTIZED TENSOR

END

FIG. 8

COMPUTER 300

301 CPU

302 INPUT DEVICE

303 DISPLAY

304 COMMUNICATION DEVICE

305 INTERFACE DEVICE

308

306 RAM
- 306a CALCULATION PROCESS
- 306b SPECIFYING PROCESS
- 306c SETTING PROCESS
- 306d QUANTIZATION PROCESS

307 HARD DISK DEVICE
- 307a CALCULATION PROGRAM
- 307b SPECIFYING PROGRAM
- 307c SETTING PROGRAM
- 307d QUANTIZATION PROGRAM

# FIG. 9

EP 4 149 007 A1

# FIG. 10

Europäisches
Patentamt

European
Patent Office

Office européen
des brevets

# EUROPEAN SEARCH REPORT

Application Number

**EP 22 17 9044**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Anonymous: "Quantization – Neural Network Distiller", github, 18 November 2020 (2020-11-18), pages 1-8, XP055977272, Retrieved from the Internet: URL:https://web.archive.org/web/20201118080417/https://intellabs.github.io/distiller/algo_quantization.html [retrieved on 2022-11-02] * page 1 – page 4 * | 1-6 | INV. H03M7/30 G06N3/08 G06F17/17 |
| X,D | US 2019/340492 A1 (BURGER DOUGLAS C [US] ET AL) 7 November 2019 (2019-11-07) * paragraph [0081] – paragraph [0091] * | 1-6 | |

TECHNICAL FIELDS SEARCHED (IPC)

H03M
G06N
G06F

The present search report has been drawn up for all claims

| Place of search | Date of completion of the search | Examiner |
|---|---|---|
| The Hague | 4 November 2022 | Belardinelli, Carlo |

## ANNEX TO THE EUROPEAN SEARCH REPORT
## ON EUROPEAN PATENT APPLICATION NO.

EP 22 17 9044

This annex lists the patent family members relating to the patent documents cited in the above-mentioned European search report.
The members are as contained in the European Patent Office EDP file on
The European Patent Office is in no way liable for these particulars which are merely given for the purpose of information.

04-11-2022

| Patent document cited in search report | | Publication date | Patent family member(s) | | Publication date |
|---|---|---|---|---|---|
| US 2019340492 | A1 | 07-11-2019 | EP | 3788557 A1 | 10-03-2021 |
| | | | US | 2019340492 A1 | 07-11-2019 |
| | | | WO | 2019212878 A1 | 07-11-2019 |

For more details about this annex : see Official Journal of the European Patent Office, No. 12/82

EPO FORM P0459

**EP 4 149 007 A1**

**Patent documents cited in the description**

- WO 2020065874 A
- WO 2019146189 A
- US 20190340492